# EUROPÄISCHE PATENTANMELDUNG

(11) **EP 0 730 332 A1**
(43) Veröffentlichungstag der Anmeldung: **04.09.1996**
(21) Anmeldenummer: 96102691.1
(22) Anmeldetag: 22.02.1996
(51) Int. Cl.: H02H 9/04

(54) **Halbleiterbauelement mit Schutzstruktur zum Schutz vor elektrostatischer Entladung**

(30) Priorität: 02.03.1995 DE 19507313
(71) Anmelder: SIEMENS AKTIENGESELLSCHAFT, 80333 München (DE)
(72) Erfinder: Chrysostomides, Ioannis, Dipl.-Phys., 81927 München (DE); Guggenmos, Xaver, Dipl.-Ing., 85221 Dachau (DE); Nikutta, Wolfgang, Dipl.-Phys., 81541 München (DE); Reczek, Werner, Dr. Ing., 85521 Ottobrun (DE); Rieger, Johann, Dipl.-Ing., 93199 Zell (DE); Stecker, Johannes, Dr. rer. nat., 80992 München (DE); Terletzki, Hartmud, DIpl.-Ing., 81827 München (DE)

(57) **Zusammenfassung**

Wenn bei einem Halbleiterbauelement eine ESD-Schutzschaltung (13) und ein vor elektrostatischer Entladung zu schützendes Funktionselement (1) an zwei verschiedene Versorgungsleitungen (VSS2, VSS1) angeschlossen sind, werden wegen des im Vergleich zur Signalleitung (12) längeren Verbindungswegs der Versorgungsleitungen (VSS2, VSS1) parasitäre Elemente und Laufzeitunterschiede wirksam. Dadurch kann am Funktionselement (1) die zulässige Höchstspannung überschritten werden, so daß das Funktionselement (1) zerstört wird. Zur Abhilfe dieses Nachteils ist ein Klemmelement (3) vorgesehen, durch das in unmittelbarer Nähe des Funktionselements (1) die Signalleitung (12) mit der das Funktionselement versorgenden Versorgungsleitung (VSS1) verbunden ist. Bei elektrostatischer Entladung wird der Restspannungsimpuls durch das Klemmelement (30) begrenzt und die Überspannungsenergie zur Versorgungsleitung (VSS1) abgeführt.

## Beschreibung

Die Erfindung betrifft eine Halbleiterbauelement mit den Merkmalen des Oberbegriffs des Patentanspruchs 1.

Bei Halbleiterchips werden bekanntlich verschiedene im Chip enthaltene Schaltungselemente von voneinander getrennten Versorgungsleitungen mit Spannung versorgt. Dies dient dem Zweck, die jeweiligen Schaltungselemente voneinander derart zu entkoppeln, daß Schwankungen der Versorgungsspannung, die beispielsweise durch Schaltvorgänge verursacht werden, nicht in andere Schaltungselemente einkoppeln. Diese Maßnahme wird beispielsweise bei hochintegrierten Halbleiterspeichern angewandt, um die Spannungsversorgung für Treiberstufen von der Spannungsversorgung für die übrigen Schaltungselemente, insbesondere Eingangspuffern zu trennen. Die Treiberstufen ziehen bekanntlich einen relativ hohen Strom aus der Versorgungsspannung, so daß aufgrund der nicht vernachlässigbaren Bahnwiderstände und parasitären Induktivitäten und Kapazitäten der Versorgungsbahnen die Versorgungsspannung während eines solchen Stromimpules kurzzeitig verringert wird.

Derartige Halbleiterchips enthalten außerdem Schutzschaltungen zum Schutz der Ein- oder Ausgänge gegen elektrostatische Überspannungen und dadurch verursachte elektrostatische Entladungen (Electrostatic Discharge-(ESD-)Schutzelemente). Diese Elemente sind zwischen dem Eingangspad der integrierten Schaltung und dem zu schutzenden Eingangs- oder Ausgangsanschluß angeschlossen und sorgen dafür, daß beim Anliegen einer Überspannung das Schutzelement durchschaltet und der Überspannungsimpuls an eine Versorgungsspannungsleiterbahn abgeleitet wird.

Bei den bekannten Halbleiterschaltungen ist die Eingangsschutzstruktur in räumlicher Nähe des Anschlußpads vorgesehen. Das Anschlußpad wiederum ist wegen des relativ hohen zu treibenden Stroms in der Nähe des Ausgangstreibers angeordnet. Die Eingangsschutzstruktur wird folglich an diejenige Versorgungsleitung angeschlossen, aus der der Ausgangstreiber versorgt wird. Im allgemeinen weist die Verbindungsleitung zwischen dem Schutzelement und dem Schaltungseingang eine andere Leitungslänge auf als die Verbindung zwischen dem versorgungspotentialseitigen Anschluß des ESD-Schutzelements zum versorgungspotentialseitigen Anschluß der Eingangsstufe. Diese Verbindung kann durchaus auch Bondverbindungen und Anschlußpins umfassen. In praktischen Fällen liegt die Leitungslänge für die Eingangssignalleitung etwa in der Größenordnung von 1 mm, während die Leitungslänge über den Versorgungspotentialpfad in der Größenordnung von 10 mm liegt. Dann sind der Bahnwiderstand des versorgungspotentialseitigen Pfads der Verbindung zwischen ESD-Schutzelement und Eingangsstufe, deren Induktivität sowie deren parasitäre kapazitive Wirkung nicht mehr vernachlässigbar. Dies führt dazu, daß die Ableitung eines Spannungsimpulses im versorgungspotentialseitigen Pfad einen Spannungsabfall verursacht. Der Spannungsimpuls wird folglich durch das ESD-Schutzelement nicht vollständig abgebaut. Der nach dem ESD-Schutzelement verbleibende Restspannungsimpuls breitet sich dann längs der Eingangssignalleitung wesentlich schneller aus als längs des relativ langen, mit dem Einfluß der parasitären Elemente behafteten Pfads der Versorgungsleitungen. Dies führt dazu, daß der zulässige Grenzwert der an der Eingangsstufe zwischen dem Eingangssignalanschluß und dem Versorgungspotentialanschluß anliegenden Spannung überschritten wird und das dort vorliegende Schaltungselement zerstört wird.

Die Aufgabe der Erfindung besteht darin, ein in Rede stehendes Halbleiterbauelement dahingehend zu verbessern, daß die Festigkeit gegenüber elektrostatischen Entladungen erhöht wird.

Erfindungsgemäß wird diese Aufgabe durch ein Halbleiterbauelement mit den Merkmalen des Patentanspruchs 1 gelöst.

Bei der erfindungsgemäßen Lösung wird der nach dem ESD-Schutzelement und vor der Eingangsstufe verbleibende Spannungsimpuls durch das Klemmelement abgeleitet, so daß ein unmittelbar an der Eingangsstufe zwischen dem Signaleingang und dem Versorgungspotentialanschluß anliegender Restspannungsimpuls unterhalb der Zerstörungsgrenze der dort angeordneten Bauelemente der Eingangsstufe liegt. Das Klemmelement ist vorzugsweise eine in Sperrichtung geschaltete Diode, die im Fall eines Überspannungsimpulses im Durchbruch betrieben wird. Alternativ kann ein sogenannter Null-Volt-Transistor verwendet werden, dessen Gate-Source-Strecke zwischen Signalleitungsanschluß und Versorgungspotentialanschluß der Eingangsstufe geschaltet ist und dessen Gate- und Source-Anschlüsse miteinander verbunden sind. Denkbar ist auch jedes andere Schaltungselement, das nach Überschreiten einer Spannungsschwelle die Spannung begrenzt.

Das ESD-Schutzelement enthält üblicherweise einen Längswiderstand. Dieser ist bisher für den ungünstigsten Fall einer sehr kurzen Signalleitung dimensioniert gewesen. In Verbindung mit der Erfindung ist es vorteilhaft, den Widerstandswert dieses Längswiderstands der ESD-Schutzstruktur in Abhängigkeit von der daran angeschlossenen Leitungslänge zu dimensionieren, so daß die Summe der Werte von Leitungswiderstand und Längswiderstand des Schutzelements für verschiedenen Leitungslängen in etwa konstant bleibt. Dies bedeutet, daß für lange Signalleitungslängen der Längswiderstand des ESD-Schutzelements entsprechend zu verringern ist. Dadurch verringert sich die Signalausbreitungszeit längs einer langen Signalleitung, so daß insgesamt die Zugriffsgeschwindigkeit des Bausteins erhöht wird. Die Signalausbreitung längs aller Signalleitungen ist dann in etwa konstant.

Nachfolgend wird die Erfindung anhand der in der Zeichnung dargestellten Figuren näher erläutert. Es zeigen:
- Figur 1: ein elektrisches Ersatzschaltbild des erfindungsrelevanten Teils eines Halbleiterbauelements,
- Figur 2a und 2b: Realisierungsbeispiele für ein Klemmelement,
- Figur 3: eine Weiterbildung der Erfindung mit veränderbarem Längswiderstand der ESD-Schutzstruktur,
- Figur 4: ein Ausführungsbeispiel für eine ESD-Schutzstruktur und
- Figur 5: eine prinzipielle Aufsicht auf das Layout eines Halbleiterbauelements.

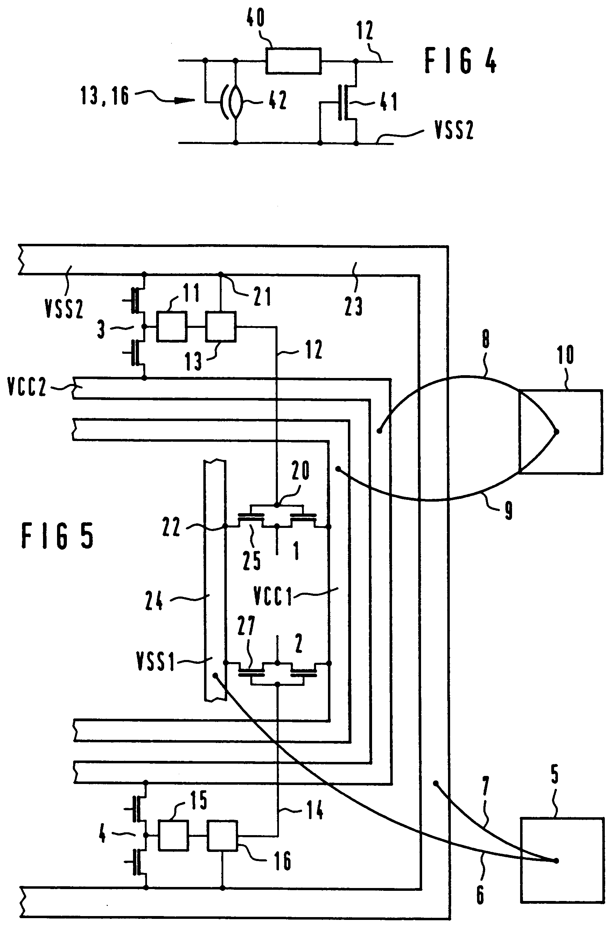

Bei dem Halbleiterbauelement gemäß Figur 5 sind zur Versorgung von Eingangsstufen der integrierten Schaltung erste Versorgungsleitungen VSS1, VCC1 vorgesehen. Das Versorgungspotential VSS1 ist das masseseitige Versorgungspotential, das Versorgungspotential VCC1 das gegenüber Masse positive Versorgungspotential. Zur Versorgung von Ausgangstreibern 3, 4 ist für beide Versorgungspotentiale je eine weitere Versorgungsleitung VSS2, VCC2 vorgesehen. Die Versorgungsleitungen für das masseseitige Versorgungspotential VSS1, VSS2 sind räumlich voneinander getrennt und nur elektrisch miteinander verbunden, so daß eine Versorgung aus der gleichen Versorgungspotentialquelle möglich ist. Zum Anschluß an die Versorgungspotentialquelle ist ein Anschlußstift 5 vorgesehen, der über Bonddrähte 6, 7 mit den Versorgungsleitungen VSS1 bzw. VSS2 verbunden ist. In entsprechender Weise sind die Versorgungsleitungen VCC1, VCC2 über jeweilige Bonddrähte 8, 9 mit einem Versorgungspin 10 verbunden. Anstelle eines einzigen Versorgungspins für die Zuführung eines Versorgungspotentials können auch getrennte Versorgungspins für die Leitungen VSS1 bzw. VSS2 oder VCC1 bzw. VCC2 vorgesehen werden, die dann über die Leiterbahnen einer gedruckten Schaltung oder den Pol der Spannungsquelle verbunden sind.

Für die Eingangsstufe 1 ist ein Anschlußpad 11 vorgesehen, das über eine Signalleitung 12 mit dem Eingang der Eingangsschaltstufe 1 verbunden ist. Zwischen Anschlußpad 11 und Eingangsstufe 1 ist ein Schutzelement 13 gegen elektrostatische Entladungen geschaltet. Das Schutzelement 13 ist mit der Versorgungsleitung VSS2 verbunden, so daß ein am Anschlußpad 11 eingekoppelter Überspannungsimpuls über die Versorgungsleitung VSS2 nach Masse abgeleitet wird. Das Anschlußpad 11 ist außerdem mit dem Ausgang des Ausgangstreibers 3 verbunden. In entsprechender Weise ist die Eingangsstufe 2 über eine Signalleitung 14 mit dem Anschlußpad 15 verbunden. Zwischen Pad 15 und Eingangstufe 2 ist außerdem in der Nähe des Pads eine ESD-Schutzstruktur 16 vorgesehen. Das Pad 15 dient außerdem als Anschlußpad für den Ausgangstreiber 4.

Die Länge der Signalleitung 12 zwischen der Eingangsschutzstruktur 13 und dem Anschluß 20 des Eingangspuffers 1 ist wesentlich geringer als die Leitungslänge zwischen dem masseseitigen Anschluß 21 zum masseseitigen Anschluß 22 der Eingangsstufe 1. Letztere Leitungslänge setzt sich nämlich zusammen aus dem Leitungsabschnitt 23 der Versorgungsleiterbahn VSS2, den Bonddrähten 7, 6 sowie dem Abschnitt 24 der Versorgungsleiterbahn VSS1. Längs dieser elektrischen Verbindung sind die jeweilgen ohmschen Bahnwiderstände sowie die parasitären Induktivitäten und Kapazitäten wirksam. Insbesondere weisen die Bonddrähte induktive Wirkung auf. Ein am Pad 11 anliegender Überspannungsimpuls wird folglich durch die Eingangsschutzstruktur 13 nicht vollständig abgebaut. Aufgrund der unterschiedlichen Signallaufzeit längs der Leitung 12 und längs des Signalpfads 23, 7, 6, 24 liegt an der Gate-Source-Strecke des Transistors 25 der Eingangsstufe 1 eine Spannung an, die zur Zerstörung des Gateoxids führen kann. Entsprechendes gilt für die Schaltstufe 2 in bezug auf das Gateoxid des Transistors 27. Da dort die Masseverbindung der Schutzstruktur 16 mit dem Transistor 27 einen kürzeren Leitungsweg aufweist, ist die Durchbruchgefahr etwas verringert, aber trotzdem noch gegeben.

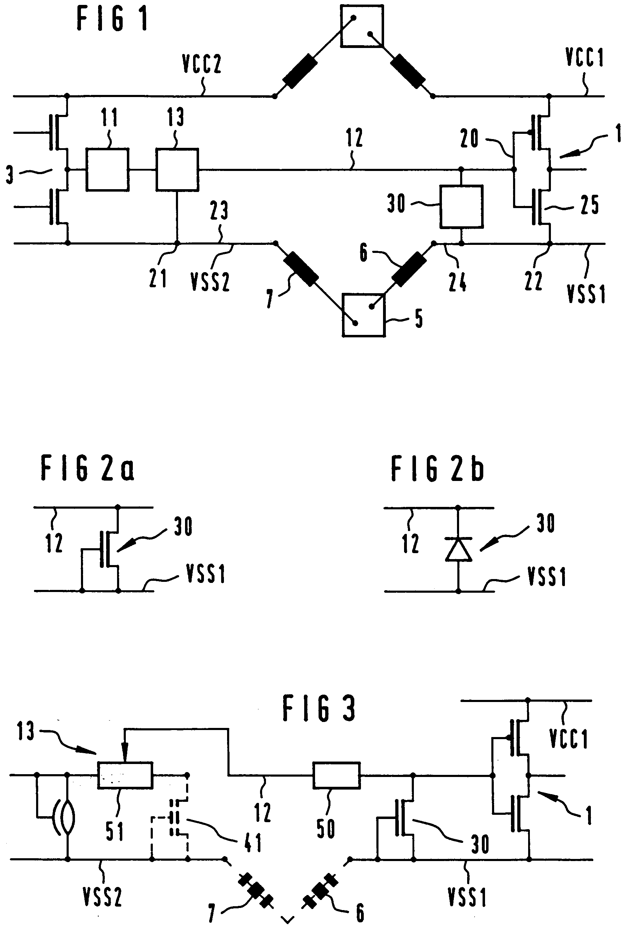

Ein elektrisches Ersatzschaltbild des die Eingangsstufe 1 betreffenden Teils des in Figur 5 gezeigten Layouts ist in Figur 1 dargestellt. Gleiche Elemente sind mit gleichen Bezugszeichen versehen. Es ist ein Klemmelement 30 vorgesehen, um den beim Auftreten eines Spannungsimpulses am Anschlußpad 11 verbleibenden Restspannungsimpuls am Gateoxid des Transistors 25 zu begrenzen. Durch das Klemmelement 30 wird die über die Gate-Source-Strecke des MOS-Transistors 25 wirksame Restspannung nach einer elektrostatischen Entladung am Pad 11 auf die vom Klemmelement 30 erzeugte Klemmspannung begrenzt. Es wird sichergestellt, daß keine unzulässig hohe Spannung am Gateoxid anliegt. Das Klemmelement weist hierzu eine Schaltschwelle auf. Überschreitet die am Klemmelement anliegende Spannung die Schaltschwelle, wird das Klemmelement leitend, so daß der Spannungsimpuls zur Masseleitung VSS1 abgeführt wird. Die Spannung wird somit auf die Klemmspannung begrenzt.

Das Klemmelement 30 ist zweckmäßigerweise in unmittelbarer Nähe des Eingangsanschlusses 20 des Eingangspuffers 1 an die Signalleitung 12 angeschlossen. Außerdem ist der masseseitige Anschluß des Klemmelements 30 in unmittelbarer Nähe des masseseitigen Anschlusses 22 des Eingangspuffers 1 an die Versorgungsleitung VSS1 angeschlossen. Die Plazierung des Elements 30 und seiner Anschlüsse muß im allgemeinen derart erfolgen, daß die Signalleitung 12 im Abschnitt 24 der Versorgungsleiterbahn VSS1 zwischen dem Anschluß des Bonddrahts 6 und dem Masseanschluß 22 des Eingangspuffers 1 verbunden wird.

Eine schaltungstechnische Realisierung für das Klemmelement 30 ist in Figur 2a und 2b angegeben. Nach Figur 2a ist das Schaltelement 30 vorzugsweise ein sogenannter Null-Volt-Transistor, dessen Drain-Source-Strecke zwischen die Signalleitung 12 und die Leiterbahn VSS1 geschaltet ist und dessen Gateanschluß ebenfalls an die Signalleitung VSS1 angeschlossen ist. Gemäß Figur 2b kann das Schaltelement 30 alternativ auch als Diode ausgeführt werden, die in Sperrichtung zwischen den Leitungen 12, VSS1 angeschlossen ist. Dies bedeutet, daß der Anodenanschluß der Diode mit der Masseleitung VSS1 verbunden ist und der Katodenanschluß mit der Signalleitung 12. Bei Aktivierung wird die Diode gemaß Figur 2b im Durchbruch betrieben. Ein entsprechendes Schaltelement wird auch zwischen die Signalleitung 14 und die Verbindungsleitung VSS1 in Nähe des Eingangspuffers 2 geschaltet.

Ein Realisierungsbeispiel für die Schutzstrukturen 13, 16 ist in Figur 4 angegeben. Die Schutzstruktur enthält einen Längswiderstand 40, der als Diffusionswiderstand realisiert sein kann. Auf Seite des Eingangspuffers ist in der Schutzstruktur ein Null-Volt-Transistor 41 vorgesehen. Padseitig ist ein Feldoxidtransistor 42 vorgesehen. Der Hauptstrompfad des Feldoxidtransistors 42 ist zwischen die Signalleitung 12 und die Versorgungsleitung VSS2 geschaltet. Der Steueranschluß des Feldoxidtransistors 42 ist mit der Signalleitung 12 verbunden. Die Steuerelektrode des Feldoxidtransistors 42 ist bekanntlich nicht als Gateoxid, wie im Fall des Transistors 41 realisiert, sondern als in vertikaler Richtung dick ausgeführtes Feldoxid. Dieses Feldoxid wird in anderen Bereichen des Halbleiterkörpers unter anderem auch zur Oberflächenisolierung verwendet.

Eine vorteilhafte Weiterbildung der Erfindung ist in Figur 3 dargestellt. Der Bahnwiderstand der Leitung 12 ist symbolisch in Form des Widerstands 50 dargestellt. Für verschiedene Eingangspuffer weist der Widerstand 50 wegen der unterschiedlichen Länge der Signalleitung 12 verschiedene Werte auf. Der Widerstandswert des Längswiderstands 51 der Schutzstruktur 13 wird bei der Herstellung derart eingestellt, daß die Summe aus längs wirksamem Widerstand 51 und Widerstand 50 bei allen Eingangspuffern im wesentlichen konstant ist. Dadurch wird erreicht, daß bei allen Eingangspuffern trotz unterschiedlicher Signalleitungslängen 12 die Signalausbreitung längs der Leitung 12 in etwa gleich ist. Der vom Widerstand 51 abgegriffene Längswiderstandswert ist also mit zunehmender Länge der Leitung 12 zu verringern. Der größtmögliche Widerstandswert ist dabei auf den ungünstigsten Fall abgestimmt, der die kürzeste Signalleitung 12 betrifft. Durch das Klemmelement 30 ist gewährleistet, daß die ESD-Festigkeit der Schaltung erhalten bleibt. Der Null-Volt-Transistor 41 kann für diesen Anwendungsfall optional verwendet werden.

## Patentansprüche

1. Halbleiterbauelement enthaltend:
- einen Halbleiterkörper, der ein Anschlußpad (11) aufweist, das über eine elektrisch leitende Verbindungsleitung (12) mit einem Halbleiterfunktionselement (1) verbunden ist,
- ein Schutzelement (13) zum Schutz vor elektrostatischer Entladung, das zwischen das Anschlußpad (11) und das Halbleiterfunktionselement (1) geschaltet ist,
- eine erste Versorgungsleitung (VSS1) für ein erstes Versorgungspotential, an die das Halbleiterfunktionselement (1) angeschlossen ist,
- eine zweite Versorgungsleitung (VSS2) für das erste Versorgungspotential, an die das Schutzelement (13) angeschlossen ist und die elektrisch leitend mit der ersten Versorgungsleitung (VSS1) verbunden ist,
**gekennzeichnet durch**
ein Klemmelement (30), das an die Verbindungsleitung (12) und die erste Versorgungsleitung (VSS1) angeschlossen ist und durch das eine am Klemmelement anliegende Spannung auf einen Klemmwert begrenzt wird.

2. Halbleiterbauelement nach Anspruch 1, **dadurch gekennzeichnet**, daß die erste und die zweite Versorgungsleitung (VSS1, VSS2) über mindestens eine Bondverbindung (6, 7) miteinander verbunden sind.

3. Halbleiterbauelement nach Anspruch 1 oder 2, **dadurch gekennzeichnet**, daß das Klemmelement (30) an denjenigen Abschnitt der ersten Versorgungsleitung (VSS1) angeschlossen ist, der zwischen dem Anschluß (22) des Halbleiterfunktionselements (1) und dem Anschluß der Bondverbindung (6) liegt.

4. Halbleiterbauelement nach einem der Ansprüche 1 bis 3, **dadurch gekennzeichnet**, daß ein erster Anschluß des Klemmelements (30) an die erste Versorgungsleitung (VSS1) und ein zweiter Anschluß des Klemmelements an die Verbindungsleitung (12) in unmittelbarer räumlicher Nähe von jeweiligen Anschlüssen des Halbleiterfunktionselements (1) an diese Leitungen (VSS1, 12) liegen.

5. Halbleiterbauelement nach einem der Ansprüche 1 bis 4, **dadurch gekennzeichnet**, daß das Klemmelement (30) einen MOS-Transistor enthält, dessen Hauptstrompfad mit der Verbindungsleitung (12) und der ersten Versorgungsleitung (VSS1) verbunden ist und dessen Gateanschluß mit der ersten Versorgungsleitung (VSS1) verbunden ist.

6. Halbleiterbauelement nach einem der Ansprüche 1 bis 4, **dadurch gekennzeichnet**, daß das Klemmelement (30) eine Diode ist, die mit der Verbindungsleitung (12) und der ersten Versorgungsleitung (VSS1) verbunden ist und von der Verbindungsleitung zur ersten Versorgungsleitung hin in Sperrichtung orientiert ist.

7. Halbleiterbaulement nach einem der Ansprüche 1 bis 6, **dadurch gekennzeichnet**, daß das Schutzelement (13) einen Widerstand (51) enthält, der zwischen das Anschlußpad (11) und das Halbleiterfunktionselement (1) geschaltet ist, daß der Widerstandswert des Widerstands (51) derart eingestellt ist, daß die Summe aus diesem Widerstandswert und dem Widerstandswert (50) der Verbindungsleitung (12) einen vorgegebenen Wert aufweist.

8. Halbleiterbauelement nach Anspruch 7, **dadurch gekennzeichnet**, daß eine Vielzahl von Schutzelementen (13) und über jeweilige Verbindungsleitungen (12) an diese Schutzelemente (13) angeschlossene Halbleiterfunktionselemente (1) vorgesehen sind und daß die Summe aus dem Widerstandswert der jeweiligen Widerstände (51) der Schutzelemente und dem Widerstandswert (50) der Verbindungsleitungen (12) für diese Vielzahl im wesentlichen konstant ist.

9. Halbleiterbauelement nach Anspruch 7 oder 8, **dadurch gekennzeichnet**, daß daß das Schutzelement (13) einen Feldoxidtransistor (42) enthält, dessen Hauptstrompfad zwischen das Anschlußpad (11) und die zweite Versorgungsleitung (VSS2) geschaltet ist und dessen Gateanschluß mit dem Anschlußpad (11) verbunden ist.

10. Halbleiterbauelement nach einem der Ansprüche 1 bis 9, **dadurch gekennzeichnet**, daß das Halbleiterfunktionselement (1) eine Eingangsschaltstufe ist und daß eine an das Anschlußpad (11) angeschlossene Ausgangstreiberstufe (3) vorgesehen ist, die an die zweite Versorgungsleitung (VSS2) angeschlossen ist.
